# EUROPEAN PATENT APPLICATION

(11) **EP 4 811 978 A1**
(43) Date of publication of application: **23.09.2026**
(21) Application number: 24908107.6
(22) Date of filing: 19.12.2024
(51) Int. Cl.: H10H 20/825, H10H 20/812, H10H 20/815, H10H 20/816

(54) **NITRIDE-BASED LONG-WAVELENGTH LIGHT-EMITTING DIODE**

(30) Priority: 19.12.2023 US 202363612030 P; 19.12.2023 US 202363612058 P; 20.12.2023 US 202363612611 P; 22.01.2024 US 202463623494 P; 06.02.2024 US 202463550223 P; 26.02.2024 US 202463557850 P; 18.03.2024 US 202463566539 P; 18.12.2024 US 202418986328
(71) Applicant: Seoul Viosys Co., Ltd., Ansan-si, Gyeonggi-do 15429 (KR)
(72) Inventor: YOO, Hong Jae, Ansan-Si Gyeonggi-do 15429 (KR)
(74) Representative: Isarpatent
(86) International application number: PCT/KR2024/020694
(87) International publication number: WO 2025/135824

(57) **Abstract**

A red light emitting apparatus according to an exemplary embodiment of the present disclosure includes a first conductivity type semiconductor layer; an active region including a barrier layer and a well layer; a strain control layer disposed between the first conductivity type semiconductor layer and the active region; a superlattice layer disposed between the strain control layer and the active region; a second conductivity type semiconductor layer disposed on the active region; and an electron blocking layer disposed between the active region and the second conductivity type semiconductor layer, in which the first conductivity type semiconductor layer and the well layer are expressed by the following formula (1), and an index value P5 representing a band gap of the well layer and an index value P1 representing a band gap of the first conductivity type semiconductor layer satisfy the following equation 1:
(Formula 1) AₓB_{y}C_{z}D_{(1-x-y-z)} (where A is an element selected from Al, In, and Ga, B is an element selected from Al, In, and Ga, C is an element selected from Al, In, and Ga, D is nitrogen, A, B, and C are different elements from one another, x+y+z=0.5, and 0≤x, y, z≤0.5); and ${\left(αx+βy+γz\right)}_{P 5} - {\left(αx+βy+γz\right)}_{P 1} < 0$ (where α, β, and γ represent band gaps of AD, BD, and CD, respectively).

## Description

### [Technical Field]

The present disclosure relates to a light emitting diode, and more particularly, to a nitride-based light emitting diode that emits light with a longer wavelength than green light, for example, red light, and a light emitting apparatus and an application having the same.

### [Background Art]

A compound semiconductor is used as a light source in a display apparatus, a traffic light, lighting, or an optical communication apparatus. A nitride semiconductor is mainly used in a light emitting diode or a laser diode that emits ultraviolet, blue, or green light.

The light emitting diode emitting blue and green light as an InGaN-based nitride semiconductor is widely used in lighting and display fields. The InGaN-based nitride semiconductor has attracted a lot of attention as a light source of blue and green light, especially in the field of large-area micro LED displays and head mounted displays (HMDs).

A lighting apparatus and a display apparatus require red light along with blue and green light. Red light has a longer wavelength than that of green light, is sensitive to temperatures, and exhibits a phenomenon in which its color changes depending on an observation angle.

### [Disclosure]

### [Technical Problem]

Exemplary embodiments of the present disclosure provide a nitride-based light emitting diode that emits light with a longer wavelength than that of green light, for example, a nitride-based red light emitting diode.

Exemplary embodiments of the present disclosure provide a light emitting diode that is configured to easily change color temperatures across yellow and red regions.

Exemplary embodiments of the present disclosure provide a nitride-based red light emitting diode having a relatively small decrease in external quantum efficiency with increasing current density compared to blue and green light emitting diodes.

Exemplary embodiments of the present disclosure provide various applications employing a nitride-based light emitting diode that emits light with a longer wavelength than that of green light, for example, red light.

### [Technical Solution]

According to an embodiment of the present disclosure, a light emitting diode includes: a first conductivity type semiconductor layer; an active region including a barrier layer and a well layer; a strain control layer disposed between the first conductivity type semiconductor layer and the active region; a superlattice layer disposed between the strain control layer and the active region; a second conductivity type semiconductor layer disposed on the active region; and an electron blocking layer disposed between the active region and the second conductivity type semiconductor layer, and emits light of a spectrum having a main peak together with at least one auxiliary peak.

An intensity of the auxiliary peak may be less than 10% of that of the main peak.

An area formed by the spectrum around the auxiliary peak may be less than 10% of an area formed by the spectrum around the main peak.

A wavelength of the main peak may be longer than 580 nm, and a wavelength of the auxiliary peak may be shorter than 500 nm.

The at least one auxiliary peak may include an auxiliary peak having a peak wavelength within a range of 400 nm to 430 nm.

The main peak may shift toward shorter wavelengths as a current increases.

The light emitting diode may emit light with higher color purity as the current increases.

The superlattice layer may include a lower superlattice layer and an upper superlattice layer, the lower superlattice layer and the upper superlattice layer may be formed of InGaN/GaN, and an In content of the upper superlattice layer may be greater than that of the upper superlattice layer.

An InGaN layer within the lower superlattice layer may be thicker than an InGaN layer within the upper superlattice layer.

The electron blocking layer may include a lower layer in contact with the active region, an upper layer in contact with the second conductivity type semiconductor layer, and an intermediate layer disposed between the lower layer and the upper layer, and the lower layer, the intermediate layer, and the upper layer may be nitride-based semiconductor layers having different compositions from one another.

The lower layer may be an AlN layer, the intermediate layer may be an InAlGaN layer, and the upper layer may be an AlGaN grading layer.

An application according to an embodiment of the present disclosure includes the light emitting diode described above as a light source.

The application may be a lighting apparatus, in which the lighting apparatus further includes a substrate having interconnections, and the light emitting diode may be disposed on the substrate.

The application may be a display apparatus.

The display apparatus may be a head mounted display apparatus.

The light emitting diode may be disposed in a pixel to implement an image.

The head mounted display apparatus may include a sensing apparatus, and the light emitting diode may be used as a light source of the sensing apparatus.

The application may be a vehicle including a tail light, and the light emitting diode may be used as a light source of the tail light.

The application may be a skin treatment apparatus.

The skin treatment apparatus may change a depth of the skin to be treated by changing the current applied to the light emitting diode.

According to an embodiment of the present disclosure, a nitride-based light emitting diode includes: a first conductivity type semiconductor layer; an active region including a barrier layer and a well layer; a strain control layer disposed between the first conductivity type semiconductor layer and the active region; a superlattice layer disposed between the strain control layer and the active region; a second conductivity type semiconductor layer disposed on the active region; and an electron blocking layer disposed between the active region and the second conductivity type semiconductor layer, in which the active region is configured to emit red light, and has a maximum external quantum efficiency within a current density range of 4 A/cm² to 20 A/cm², and the external quantum efficiency within a current density range of 10 A/cm² to 20A/cm² is greater than or equal to 90% of the maximum external quantum efficiency.

A normalized external quantum efficiency graph of the nitride-based light emitting diode may have a negative slope at a first point P1 of the current density of 20 A/cm².

The superlattice layer may include a lower superlattice layer and an upper superlattice layer, the lower superlattice layer and the upper superlattice layer may be formed of InGaN/GaN, and an In content of the upper superlattice layer may be greater than that of the upper superlattice layer.

The electron blocking layer may include a lower layer in contact with the active region, an upper layer in contact with the second conductivity type semiconductor layer, and an intermediate layer disposed between the lower layer and the upper layer, and the lower layer, the intermediate layer, and the upper layer may be nitride-based semiconductor layers having different compositions from one another.

The upper layer may be a grading layer in which an Al content thereof decreases as it gets farther from the active region.

The lower layer may be an AlN layer, the intermediate layer may be an InAlGaN layer, and the upper layer may be an AlGaN grading layer.

A light emitting apparatus according to an embodiment of the present disclosure includes the nitride-based light emitting diode described above.

The light emitting apparatus may further include a nitride-based blue light emitting diode, and within a current density range of 10 A/cm² to 20 A/cm², a normalized external quantum efficiency of the nitride-based light emitting diode may have a value greater than a normalized external quantum efficiency of the nitride-based blue light emitting diode.

The light emitting apparatus may further include a nitride-based green light emitting diode, and within the current density range of 10 A/cm² to 20 A/cm², the normalized external quantum efficiency of the nitride-based light emitting diode may have a value greater than a normalized external quantum efficiency of the nitride-based green light emitting diode.

The normalized external quantum efficiency graph of the nitride-based light emitting diode may have the negative slope at the first point P1 of the current density of 20 A/cm².

An absolute value of the negative slope may be smaller than absolute values of slopes of the normalized external quantum efficiency graphs of the nitride-based blue and green light emitting diodes at the current density of 20 A/cm².

A current density exhibiting a maximum external quantum efficiency of the nitride-based light emitting diode may be higher than current densities exhibiting maximum external quantum efficiencies of the nitride-based blue and green light emitting diodes.

The external quantum efficiency graph according to the current density of the nitride-based light emitting diode may intersect with the external quantum efficiency graphs according to current densities of the nitride-based blue and green light emitting diodes at a second point P2 and a third point P3, respectively, and the current densities of the second point P2 and the third point P3 may be smaller than 10 A/cm².

The normalized external quantum efficiency graph of the nitride-based light emitting diode may have a positive slope at the second point P2.

The normalized external quantum efficiency graph of the nitride-based blue light emitting diode may have a negative slope at the second point P2.

The positive slope may be greater than an absolute value of the negative slope.

The normalized external quantum efficiency graph of the nitride-based light emitting diode may have a positive slope at the third point P3.

The normalized external quantum efficiency graph of the nitride-based green light emitting diode may have a negative slope at the third point P3.

Furthermore, the positive slope may be greater than an absolute value of the negative slope.

Within the current density range of less than or equal to 20A/cm², a minimum radius of curvature of the normalized external quantum efficiency graph of the nitride-based light emitting diode may be greater than minimum radii of curvature of the normalized external quantum efficiency graphs of the nitride-based blue and green light emitting diodes.

According to an embodiment of the present disclosure, a light emitting diode is a light emitting diode that emits red light, which includes: a first conductivity type semiconductor layer; an active region including a barrier layer and a well layer; a strain control layer disposed between the first conductivity type semiconductor layer and the active region; a superlattice layer disposed between the strain control layer and the active region; a second conductivity type semiconductor layer disposed on the active region; and an electron blocking layer disposed between the active region and the second conductivity type semiconductor layer, in which a composition of each layer is expressed by the following formula 1, in which an index value P5 representing a band gap of the well layer and an index value P1 representing a band gap of the first conductivity type semiconductor layer satisfy the following equation 1:
(Formula 1) AₓB_{y}C_{z}D_{(1-x-y-z)} (where A is an element selected from Al, In, or Ga, B is an element selected from Al, In, or Ga, and C is an element selected from Al, In, or Ga, D is nitrogen, A, B, and C are different elements from one another, x+y+z=0.5, and 0≤x, y, z≤0.5); and
${\left(αx+βy+γz\right)}_{P 5} - {\left(αx+βy+γz\right)}_{P 1} < 0$ (where α, β, and γ represent band gaps of AD, BD, and CD, respectively).

The superlattice layer may have a structure in which a first layer and a second layer are alternately stacked, and the first layer contains more In than the second layer, and the index value P5 representing the band gap of the well layer and an index value P2 representing a band gap of the first layer of the superlattice layer may satisfy the following equation 2:
${\left(αx+βy+γz\right)}_{P 5} - {\left(αx+βy+γz\right)}_{P 2} < 0 .$

The index value P5 representing the band gap of the well layer and an index value P3 representing a band gap of the second layer of the superlattice layer may satisfy the following equation 3:
${\left(αx+βy+γz\right)}_{P 5} - {\left(αx+βy+γz\right)}_{P 3} < 0 .$

The index value P5 representing the band gap of the well layer and an index value P4 representing a band gap of the barrier layer may satisfy the following equation 4:
${\left(αx+βy+γz\right)}_{P 5} - {\left(αx+βy+γz\right)}_{P 4} < 0 .$

The well layer may be in contact with two barrier layers, and the well layer and the two barrier layers may satisfy the Equation 4, respectively.

The index value P5 representing the band gap of the well layer and an index value P6 representing a band gap of the electron blocking layer may satisfy the following equation 5:
${\left(αx+βy+γz\right)}_{P 5} - {\left(αx+βy+γz\right)}_{P 6} < 0 .$

The index value P5 representing the band gap of the well layer and an index value P7 representing a band gap of the second conductivity type semiconductor layer may satisfy the following equation 6:
${\left(αx+βy+γz\right)}_{P 5} - {\left(αx+βy+γz\right)}_{P 7} < 0 .$

The index value P4 representing the band gap of the barrier layer and the index value P1 representing the band gap of the first conductivity type semiconductor layer may satisfy the following equation 7:
${\left(αx+βy+γz\right)}_{P 4} - {\left(αx+βy+γz\right)}_{P 1} \geq 0 .$

The index value P4 representing the band gap of the barrier layer may be greater than the index value P1 representing the band gap of the first conductivity type semiconductor layer.

The index value P4 representing the band gap of the barrier layer and the index value P3 representing the band gap of the first layer of the superlattice layer may satisfy the following equation 8:
${\left(αx+βy+γz\right)}_{P 4} - {\left(αx+βy+γz\right)}_{P 3} \geq 0 .$

The index value P4 representing the band gap of the barrier layer and the index value P6 representing the band gap of the electron blocking layer may satisfy the following equation 9:
${\left(αx+βy+γz\right)}_{P 4} - {\left(αx+βy+γz\right)}_{P 6} < 0 .$

The index value P4 representing the band gap of the barrier layer and the index value P7 representing the band gap of the second conductivity type semiconductor layer may satisfy the following Equation 10:
${\left(αx+βy+γz\right)}_{P 4} - {\left(αx+βy+γz\right)}_{P 7} \geq 0 .$

The index value P4 representing the band gap of the barrier layer may be greater than the index value P7 representing the band gap of the second conductivity type semiconductor layer.

The superlattice layer has a structure in which the first layer and the second layer are alternately stacked, the first layer contains more In than the second layer, and the index value P3 representing the band gap of the second layer of the superlattice layer and the index value P1 representing the band gap of the first conductivity type semiconductor layer may satisfy the following equation 11:
${\left(αx+βy+γz\right)}_{P 3} - {\left(αx+βy+γz\right)}_{P 1} \leq 0 .$

The index value P3 representing the band gap of the second layer of the superlattice layer and the index value P7 representing the band gap of the second conductivity type semiconductor layer may satisfy the following equation 12:
${\left(αx+βy+γz\right)}_{P 3} - {\left(αx+βy+γz\right)}_{P 7} \leq 0 .$

The index value P3 representing the band gap of the second layer of the superlattice layer may be smaller than the index value P7 representing the band gap of the second conductivity type semiconductor layer.

The light emitting diode may further include a lower superlattice layer interposed between the superlattice layer and the strain control layer.

The electron blocking layer may include an inclination composition layer.

The light emitting diode may emit red light having a peak wavelength within a range of 600 nm to 720 nm.

At least one of the barrier layers may include a reference band gap layer and a protruding band gap layer, and an index value P8 representing a band gap of the protruding band gap layer and an index value P4 representing a band gap of the reference band gap layer may satisfy the following equation 13:
${\left(αx+βy+γz\right)}_{P 8} - {\left(αx+βy+γz\right)}_{P 4} > 0 .$

The index value P8 representing the band gap of the protruding band gap layer and the index value P6 representing the band gap of the electron blocking layer may satisfy the following equation 14:
${\left(αx+βy+γz\right)}_{P 8} - {\left(αx+βy+γz\right)}_{P 6} > 0 .$

The protruding band gap layer is disposed in barrier layers other than a last barrier layer of the active region.

The protruding band gap layer may be an AlN layer.

### [Description of Drawings]

FIG. 1 is a schematic cross-sectional view illustrating a red light emitting diode according to an embodiment of the present disclosure.
FIG. 2 is an enlarged cross-sectional view of a lower superlattice layer of FIG. 1.
FIG. 3 is an enlarged cross-sectional view of an upper superlattice layer of FIG. 1.
FIG. 4 is an enlarged cross-sectional view of an active layer of FIG. 1.
FIG. 5 is an enlarged cross-sectional view of an electron blocking layer of FIG. 1.
FIG. 6 is an enlarged cross-sectional view of the second conductivity type semiconductor layer of FIG. 1.
FIG. 7 is a graph showing a spectrum of light emitted from a light emitting diode according to an embodiment of the present disclosure.
FIG. 8A is a graph showing a spectrum of light emitted from a light emitting diode according to an embodiment of the present disclosure.
FIG. 8B is an enlarged graph of a portion of FIG. 8A.
FIG. 9 shows color coordinates of a light emitting diode according to an embodiment of the present disclosure.
FIG. 10 is a schematic cross-sectional view illustrating a lighting apparatus according to an embodiment of the present disclosure.
FIG. 11 is a schematic cross-sectional view illustrating a lighting apparatus according to another embodiment of the present disclosure.
FIG. 12 is a schematic plan view illustrating a head mounted display according to an embodiment of the present disclosure.
FIG. 13 is a schematic rear view illustrating a vehicle equipped with a light emitting diode according to an embodiment of the present disclosure.
FIG. 14A is a graph illustrating external quantum efficiencies of light emitting diodes according to current densities.
FIG. 14B is a graph showing an enlarged portion of FIG. 14A.
FIG. 15 is a schematic plan view illustrating a light emitting module according to an embodiment of the present disclosure.
FIG. 16 is a schematic plan view illustrating a display apparatus according to an embodiment of the present disclosure.
FIG. 17 is a schematic cross-sectional view illustrating a light emitting diode according to an embodiment of the present disclosure.
FIG. 18 is a schematic diagram illustrating a band gap of each layer of a light emitting diode according to an embodiment of the present disclosure.
FIG. 19 is an enlarged cross-sectional view of a superlattice layer of FIG. 18.
FIG. 20 is a band diagram illustrating a light emitting diode according to another embodiment of the present disclosure.
FIG. 21 is an enlarged cross-sectional view of an active region of a light emitting diode according to another embodiment of the present disclosure.
FIG. 22 is a schematic cross-sectional view illustrating a light emitting apparatus according to an embodiment of the present disclosure.

### [Detailed Description of Embodiments]

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hardwired circuits, memory elements, interconnection connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

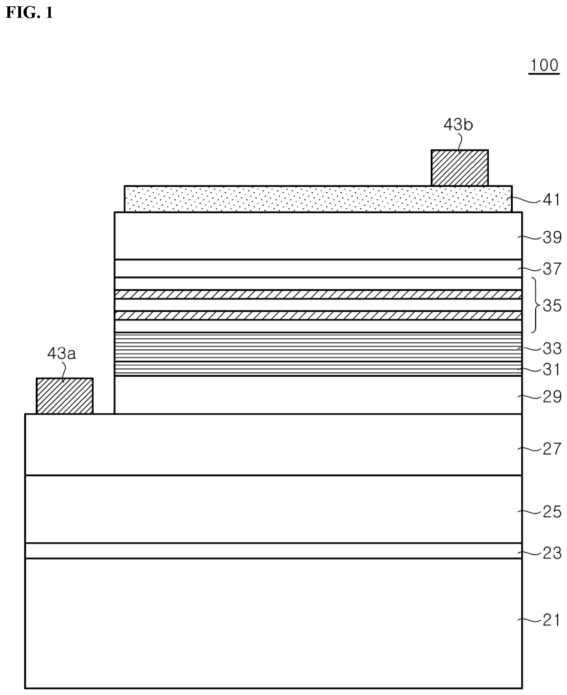

FIG. 1 is a schematic cross-sectional view illustrating a light emitting diode 100 according to an embodiment of the present disclosure.

Referring to FIG. 1, the light emitting diode 100 may include a substrate 21, a buffer layer 23, an undoped layer 25, a first conductivity type semiconductor layer 27, a strain control layer 29, and a lower superlattice layer 31, an upper superlattice layer 33, an active region 35, an electron blocking layer 37, a second conductivity type semiconductor layer 39, a transparent electrode layer 41, a first electrode 43a, and a second electrode 43b.

The substrate 21 may be a growth substrate for growing a gallium nitride-based semiconductor layer, for example, a sapphire substrate, a silicon substrate, a SiC substrate, a spinel substrate, or a Ga₂O₃ substrate. In an exemplary embodiment, the substrate 21 may be a patterned sapphire substrate. The substrate 21 may be removed from light emitting diode 100.

The buffer layer 23 is a low-temperature buffer layer, for example, a nucleation layer for growing a gallium nitride-based semiconductor layer on a heterogeneous substrate, and may be formed of, for example, an AlGaN layer. The undoped layer 25 is, for example, a high-temperature buffer layer, and may include a gallium nitride-based semiconductor layer, for example, a GaN layer.

The first conductivity type semiconductor layer 27 may be a semiconductor layer including an n-type impurity, for example, Si. The first conductivity type semiconductor layer 27 may be a contact layer on which the first electrode 43a is formed. For example, the first conductivity type semiconductor layer 27 may be formed of GaN.

The strain control layer 29 is disposed between the first conductivity type semiconductor layer 27 and the active region 35. The active region 35 includes a high In content In to generate light of a relatively long-wavelength by recombination of electrons and holes. Accordingly, a lattice constant of the active region 35 is larger than that of the first conductivity type semiconductor layer 27, and thus, strain occurs in the active region 35. The strain control layer 29 is formed to control strain generated in the active region 35.

The strain control layer 29 may be formed as a single layer or multiple layers, and may have a thickness of, for example, within a range of about 200 nm to about 300 nm. The strain control layer 29 may include a V-pit generation layer for generating V-pits. For example, the strain control layer 29 may be formed as a nitride layer having a same composition as that of the first conductivity type semiconductor layer 27, but may be formed at a temperature lower than a growth temperature of the first conductivity type semiconductor layer 27, for example, about 700 °C to about 900 °C. In particular, by using trimethylgallium (TMGa) as a Ga source, the strain control layer 29 may be grown at a relatively fast rate, and by growing it at a relatively low temperature and relatively fast, a density of a threading dislocation may be lowered and V-pits may be generated.

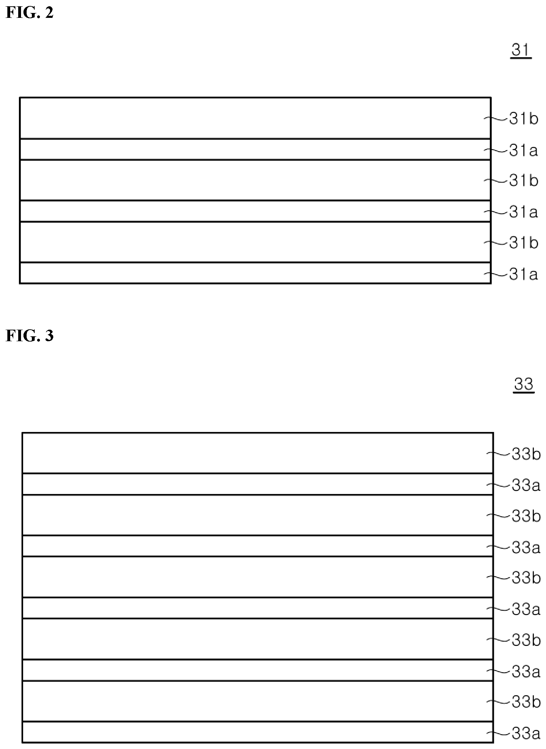

The lower superlattice layer 31 may be formed by stacking InGaN/GaN in 3 to 4 cycles. As shown in FIG. 2, a thickness of an InGaN layer 31a in the lower superlattice layer 31 may be smaller than that of a GaN layer 31b. For example, the thickness of the InGaN layer 31a may be about 2.5 nm, and the thickness of the GaN layer 31b may be about 7.5 nm. A total thickness of the lower superlattice layer 31 may be, for example, within a range of 30 nm to 40 nm, but the inventive concepts are not limited thereto. Meanwhile, regarding overall compositions of In, Ga, and N, an In composition ratio of InGaN may be within a range of 0.01 to 0.025, and a Ga composition ratio may be within a range of 0.475 to 0.49.

The upper superlattice layer 33 may be formed of InGaN/GaN, and may be formed by stacking them in more cycles, for example, 5 to 6 cycles, than the lower superlattice layer 31. As shown in FIG. 3, a thickness of an InGaN layer 33a within the superlattice layer 33 may be smaller than that of a GaN layer 33b. In addition, the thickness of the InGaN layer 33a in the superlattice layer 33 may be smaller than that of the InGaN layer 31a in the lower superlattice layer 31. For example, the thickness of the InGaN layer 33a within the superlattice layer 33 may be about 2.0 nm, and the thickness of the GaN layer 33b may be about 8.0 nm. A total thickness of the superlattice layer 33 may be greater than that of the lower superlattice layer 31, and may be, for example, within a range of about 50 nm to about 60 nm, but it is not limited thereto.

An In composition ratio of InGaN in the superlattice layer 33 may be greater than that of InGaN in the lower superlattice layer 31. For example, regarding overall compositions of In, Ga, and N, the In composition ratio of InGaN in the superlattice layer 33 may be within a range of 0.025 to 0.05. Meanwhile, regarding the overall compositions of In, Ga, and N, a Ga composition ratio in InGaN in the upper superlattice layer 33 may be within a range of 0.45 to 0.475.

The lower superlattice layer 31 and the upper superlattice layer 33 may be grown at a relatively slow rate using triethylgallium (TEGa) as a Ga source. The V-pit is generated by the strain control layer 29 grown relatively fast at a low temperature, and a size of the V-pit increases by the lower superlattice layer 31 and the upper superlattice layer 33. In particular, by growing the lower and upper superlattice layers 31 and 33 using the TEGa source, V-pits with relatively uniform densities and sizes may be formed over an entire wafer area. The size and uniformity of the V-pit may be varied by adjusting a growth condition and thickness of the strain control layer 29 and a growth conditions and thicknesses of the lower and upper superlattice layers 31 and 33.

By forming the lower superlattice layer 31 and the upper superlattice layer 33 as InGaN/GaN superlattice layers with similar structures, a lattice change may be reduced, thereby reducing defects in the active region 35. In addition, by increasing the In content of the upper superlattice layer 33 compared to that of the lower superlattice layer 31, an In content of a well layer 35b within the active region 35 may be increased.

The V-pits formed by the strain control layer 29 assist to relieve strain and allow more indium to be introduced into the active region 35 formed thereon. Accordingly, a quantum well structure containing a higher indium content may be included in the active region 35 of the light emitting diode 100, and thus, long-wavelength visible light such as yellow light and red light may be easily implemented, and radiation efficiency may be improved.

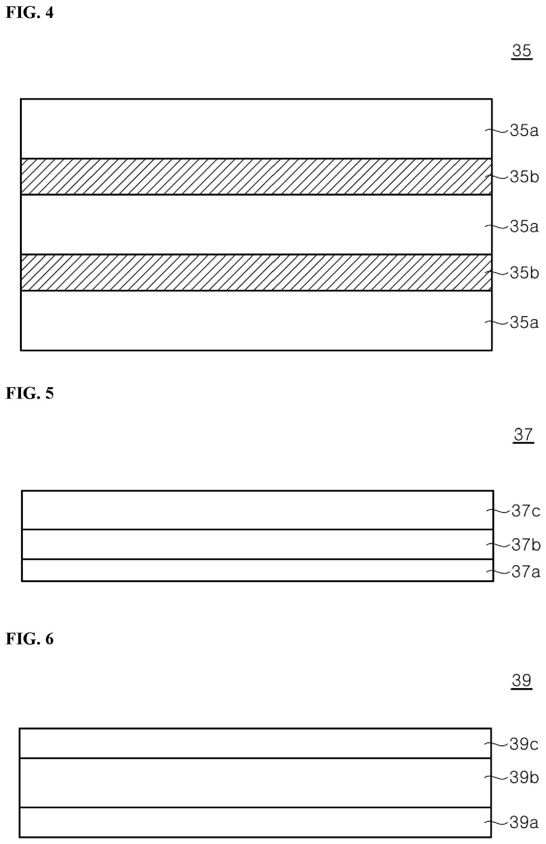

Referring to FIGs. 1 and 4, the active region 35 is disposed on the upper superlattice layer 33. The active region 35 may include a barrier layer 35a and the well layer 35b. The active region 35 may have a single quantum well structure including a single well layer 35b or a multi quantum well structure including a plurality of well layers 35b. A number of well layers 35b may be, for example, within a range of 1 to 10.

The barrier layer 35a may include a GaN layer, and the well layer 35b may include an InGaN layer. The well layer 35b includes an In content higher than that of the barrier layer 35a to generate long-wavelength light. An In composition ratio in the well layer 35b may be greater than or equal to 0.15 and less than or equal to 0.2 with respect to an overall composition in the well layer 35b. In an additional embodiment, the active region 35 may include at least one well layer having an In composition ratio with respect to the overall composition, which is smaller than the composition ratio of the well layer 35b described above and greater than the In composition ratio in the InGaN within the upper superlattice layer 33, for example, a well layer having an In composition ratio greater than or equal to 0.05 and less than 0.15 with respect to the overall composition, and a well layer having a smaller In composition ratio may be disposed closer to the upper superlattice layer 33 than a well layer having a relatively larger In composition ratio.

The barrier layer 35a and the well layer 35b may also be formed within the V-pits. The well layer 35b formed within the V-pit may contain less In than the well layer formed on a flat surface around the V-pit. Accordingly, short-wavelength light may also be generated using the well layer formed within the V-pit.

The electron blocking layer 37 is disposed on the active region 35. The electron blocking layer 37 is formed along a surface of the active region 35. The electron blocking layer 37 may include a plurality of layers 37a, 37b, and 37c, as shown in FIG. 5. A lowermost layer 37a may be in contact with a last barrier layer 35a of the active region 35, an uppermost layer 37c may be in contact with the second conductivity type semiconductor layer 39, and an intermediate layer 37b may be disposed between the lowermost layer 37a and the uppermost layer 37c. For example, the lowermost layer 37a may be formed with a thickness of about 2 nm to about 3 nm, the intermediate layer 37b may be formed with a thickness of about 10 nm to about 15 nm, and the uppermost layer 37c may be formed with a thickness of about 12 nm to about 20 nm.

The intermediate layer 37b may include a higher concentration of a p-type impurity than those of the lowermost layer 37a and the uppermost layer 37c. For example, the intermediate layer 37b may include Mg doped at a high concentration of about 1×10²⁰/cm³ to about 3×10²⁰/cm³.

Each layer within the electron blocking layer 37 may include Al. The lowermost layer 37a may be, for example, an AlN layer. In addition, the uppermost layer 37c may be a grading layer in which a composition ratio of Al decreases as it gets farther from the active region 35. For example, the uppermost layer 37c may be an AlGaN grading layer. In addition, an Al composition ratio of the intermediate layer 37b may be smaller than that of the lowermost layer 37a, may be smaller than a maximum Al composition ratio and larger than a minimum Al composition ratio in the uppermost layer 37c, which is the grading layer. For example, the intermediate layer 37b may be an InAlGaN layer.

The second conductivity type semiconductor layer 39 may be disposed on the electron blocking layer 37. The second conductivity type semiconductor layer 39 may fill the V-pits, but the inventive concepts are not limited thereto. For example, the second conductivity type semiconductor layer 39 may be formed along the V-pits, and thus, grooves corresponding to the V-pits may remain on a surface of the second conductivity type semiconductor layer 39.

The second conductivity type semiconductor layer 39 may be a nitride semiconductor layer doped with a p-type impurity, such as Mg. The second conductivity type semiconductor layer 39 may include, for example, a GaN layer. The second conductivity type semiconductor layer 39 may be a contact layer on which an ohmic electrode is formed. As illustrated in FIG. 6, the second conductivity type semiconductor layer 39 may include layers 39a, 39b, and 39c having different doping concentrations of p-type impurities such as Mg. A first layer 39a may be in contact with the electron blocking layer 37, and an ohmic contact may be formed in the third layer 39c. A second layer 39b may be disposed between the first layer 39a and a third layer 39c. The first layer 39a, the second layer 39b, and the third layer 39c may have different doping concentrations from one another. For example, the second layer 39b may have a higher doping concentration than that of the first layer 39a, and the third layer 39c may have a higher doping concentration than that of the second layer 39b. The doping concentration of the p-type impurity in the third layer 39c may be higher than a doping concentration in the intermediate layer 37b of the electron blocking layer 37, for example, may be within a range of 5×10²⁰/cm³ to 9×10²⁰/cm³.

The second layer 39b may be thicker than the first layer 39a and the third layer 39c. For example, the first layer 39a and the third layer 39c may have a thickness within a range of about 100 nm to about 200 nm, and the second layer 39b may have a thickness within a range of about 200 nm to about 300 nm. Each of the layers 39a, 39b, and 39c of the second conductivity type semiconductor layer 39 may be formed of, for example, a GaN layer.

The transparent electrode layer 41 may be disposed on the second conductivity type semiconductor layer 39. The transparent electrode layer 41 may be in ohmic contact with the third layer 39c. The transparent electrode layer 41 may be formed of a conductive oxide, such as indium tin oxide (ITO) or indium zinc oxide (IZO).

The first electrode 43a may be disposed on the first conductivity type semiconductor layer 27. The first electrode 43a may be in ohmic contact with the first conductivity type semiconductor layer 27. For example, the first electrode 43a may be formed of, for example, Cr/Pt/Au.

The second electrode 43b may be formed on the transparent electrode layer 41. The second electrode 43b may be formed of various metallic layers, and may also be formed of a same material as that of the first electrode 43a. The first electrode 43a and the second electrode 43b may be formed together from the same material in a same process.

In this embodiment, the transparent electrode layer 41 is illustrated and described as being in ohmic contact with the second conductivity type semiconductor layer 39, but the inventive concepts are not necessarily limited thereto, and instead of the transparent electrode layer 41, a metallic layer may be in ohmic contact with the second conductivity type semiconductor layer 39.

According to the embodiments of the present disclosure, a nitride-based light emitting diode is provided, which emits light with a longer wavelength than green light. For example, a nitride-based red light emitting diode may be provided. The nitride-based red light emitting diode may be used in a lighting apparatus and a display apparatus together with nitride-based blue and green light emitting diodes. The nitride-based light emitting diode according to the embodiments of the present disclosure may maintain luminous efficiency even in a small size, and in addition, may be suitably used in a micro LED display due to its low sensitivity to temperature.

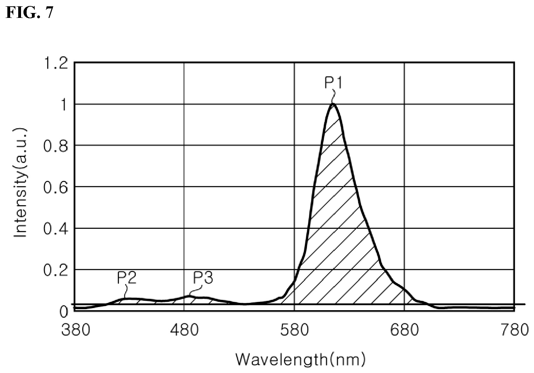

FIG. 7 is a graph showing a spectrum of light emitted from a light emitting diode according to an embodiment of the present disclosure.

Referring to FIG. 7, light emitted from the light emitting diode may have at least two or more peaks P1, P2, and P3. A first peak P1 is a main peak and has a higher intensity than those of the other peaks. The first peak P1 is positioned in a wavelength range longer than about 580 nm, and a second peak P2 and a third peak P3 are positioned in a wavelength range shorter than about 500 nm. The second peak P2 and the third peak P3 may be positioned in a wavelength range longer than about 400 nm. The first peak P1 as the main peak may mainly determine a color temperature of light emitted from the light emitting diode, and the second peak P2 and the third peak P3 positioned in a wavelength range shorter than the wavelength of the first peak P1 are auxiliary peaks and have a melanopic synthesis reactivity higher than that of the first peak P1, which may suppress melatonin secretion and increase a user's physical activity.

The first peak P1 may be light emitted from a well layer 35b of an active region 35. In particular, the first peak P1 may be formed by light emitted from the well layer 35b formed in a flat region. Meanwhile, the second peak P2 and the third peak P3 may be formed by light emitted from the well layer 35b formed within V-pits. When sizes of the V-pits are various, or when thicknesses of the well layers formed within the V-pits are different, auxiliary peaks of various peaks may be formed.

Intensities of the second and third peaks P2 and P3 may be less than 10% of an intensity of the first peak P1. In addition, an area formed by the spectrum around the second and third peaks P2 and P3 may be less than 10% of an area formed by the spectrum around the first peak P1. By making the intensity of the first peak P1 relatively greater than the intensities of the other peaks P2 and P3, a light emitting diode emitting visible light with high color purity and longer wavelength may be provided.

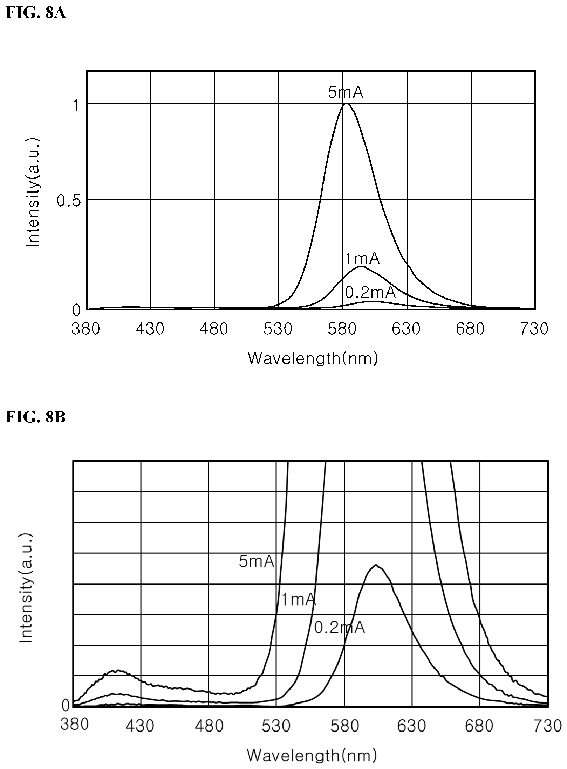

FIG. 8A is a graph showing a spectrum of light emitted from a light emitting diode according to an embodiment of the present disclosure, and FIG. 8B is an enlarged graph of a portion of FIG. 8A.

Referring to FIGs. 8A and 8B, the light emitting diode according to this embodiment exhibits an emission spectrum having two peaks. A main peak may be positioned in a wavelength range longer than about 580 nm, and an auxiliary peak may be positioned in a wavelength range shorter than about 430 nm, or further in a wavelength range shorter than about 420 nm. Meanwhile, the auxiliary peaks may be positioned in a wavelength range longer than about 400 nm. The main peak may mainly determine a color temperature, and the auxiliary peak positioned in a wavelength range shorter than the wavelength of the main peak has a higher melanopic synthesis reactivity than that of the main peak, which may suppress melatonin secretion and increase a user's physical activity.

The main peak may be light emitted from a well layer 35b of an active region 35. In particular, the main peak may be formed by light emitted from the well layer 35b formed in a flat region. Meanwhile, the auxiliary peak may be formed by light emitted from the well layer 35b formed within V-pits. When sizes of the V-pits are uniform, and thicknesses of the well layers formed within the V-pits are constant, a single auxiliary peak as shown in FIG. 8B may be formed.

An intensity of the auxiliary peak may be less than 10% of an intensity of the main peak. In addition, an area formed by the spectrum around the auxiliary peak may be less than 10% of an area formed by the spectrum around the main peak. By making the intensity of the main peak relatively greater than that of the auxiliary peak, a light emitting diode emitting visible light with high color purity and longer wavelength may be provided.

Meanwhile, the intensities of the main peak and auxiliary peak may be increased by increasing current applied to the light emitting diode. FIGs. 8A and 8B show spectra of light emitted by applying 0.2 mA, 1 mA, and 5 mA to a same light emitting diode. As the current increases, the intensities of the main peak and auxiliary peaks increase, and the wavelength of the main peak shifts toward shorter wavelengths. However, it can be seen that the wavelengths of the auxiliary peaks generally maintain a same wavelength. In addition, as the current increases in the spectrum of the main peak, a ratio of a height to a full width at half maximum also increases. Therefore, the color purity of light emitted from the light emitting diode may be improved as the current increases.

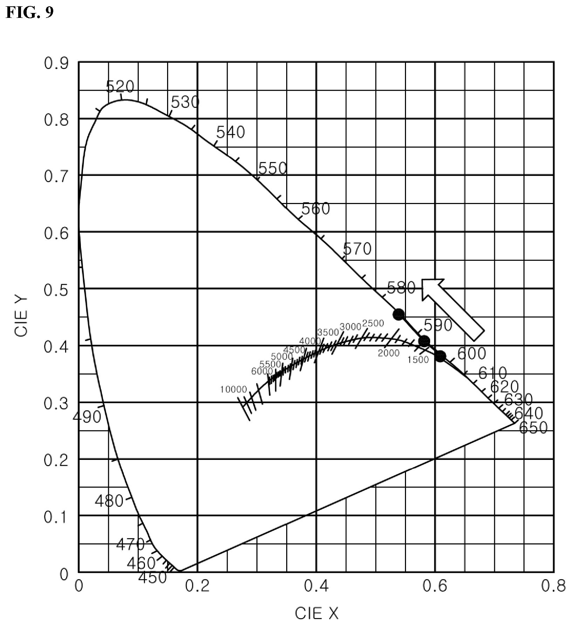

FIG. 9 shows color coordinates of a light emitting diode according to an embodiment of the present disclosure.

Referring to FIG. 9, by increasing a current applied to the light emitting diode, the color coordinates of light emitted from the light emitting diode move in a direction indicated by an arrow. For example, the light emitting diode may emit red light of about 598 nm to yellow light of about 584 nm as the current increases. CIE X coordinates may decrease as the current applied to the light emitting diode increases. In addition, CIE Y coordinates may increase as the current applied to the light emitting diode increases. That is, the CIE coordinates may move up-left as the current applied to the diode increases. Moreover, it can be seen that as the current increases, a color purity of the light emitted from the light emitting diode further improves.

The light emitting diode according to this embodiment may be used in various applications such as lighting apparatuses, display apparatuses, light source apparatuses for vehicles, and the like.

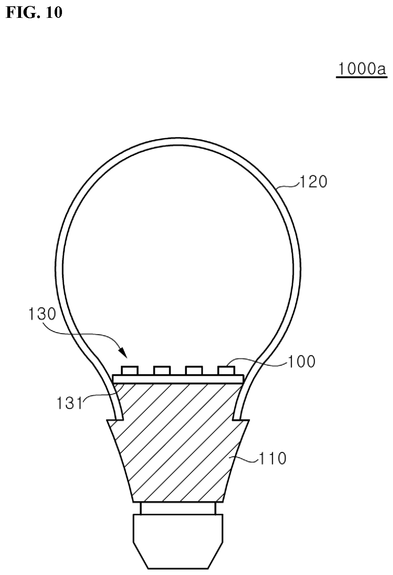

FIG. 10 is a schematic cross-sectional view illustrating a lighting apparatus according to an embodiment of the present disclosure.

Referring to FIG. 10, a lighting apparatus 1000a includes a main body 110, a cover 120, and a light emitting module 130.

The light emitting module 130 may be mounted on the main body 110. Various configurations, such as devices, interconnections, and others for driving the light emitting module 130 may be disposed inside the main body 110. In addition, the main body 110 may include a heat dissipation unit and a socket connected to an external power source.

The cover 120 may be formed of a material that transmits light. The cover 120 may be formed to cover the light emitting module 130 by being coupled to the main body 110.

The light emitting module 130 may include a substrate 131 and a light emitting diode 100. The substrate 131 may include an interconnection electrically connected to the light emitting diode 100. The substrate 131 may be a printed circuit board, without being limited thereto. The substrate 131 may be anything as long as it provides an electrical path for driving the light emitting diode 100.

One or a plurality of light emitting diodes 100 may be mounted on the substrate 131. The light emitting diode 100 is same as the light emitting diode 100 described with reference to FIG. 1, and a detailed description thereof is omitted. The light emitting diode 100 may emit light by receiving driving power through the interconnection of an electrically connected substrate 131. The substrate 131 may include a driving circuit or a driving device for driving the light emitting diode 100, and may include both the driving circuit and the driving device.

The light emitting diode 100, as illustrated in FIG. 9, may emit light with a color coordinate which moves from a red side to a yellow side as a current increases. In other words, as the current increases, the color coordinate may move up-left. Accordingly, the lighting apparatus 1000a may change a color of light emitted over ranges from red light to yellow light by adjusting the current applied to the light emitting diode 100. Such lighting apparatuses 1000a may be suitable for use in applications that emit light that changes color, such as Christmas trees. In addition, by employing the light emitting diode 100 having a first peak P1 and a second peak P2 which is an auxiliary peak having a shorter wavelength range than that of the first peak P1, the first peak P1 may determine a color temperature, and the second peak may be positioned in a region having a higher melanopic synthesis reactivity than that of the first peak P1, thereby suppressing melatonin secretion, which may implement a light emitting apparatus having an auxiliary effect of increasing a user's physical activity. In addition, when an intensity of the second peak P2 is less than 10% of an intensity of the first peak P1, the auxiliary peak does not affect the color purity, and thus, a light emitting apparatus with high color purity may be implemented.

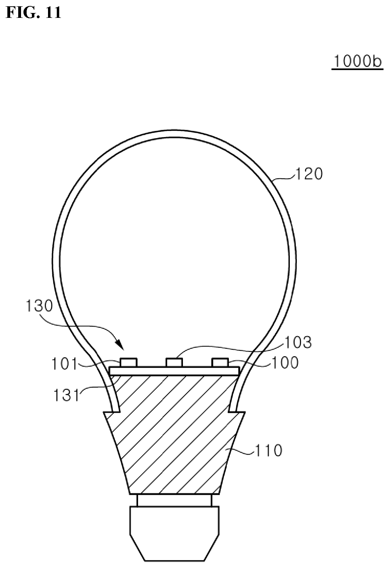

FIG. 11 is a schematic cross-sectional view illustrating a lighting apparatus according to another embodiment of the present disclosure.

Referring to FIG. 11, a lighting apparatus 1000b according this embodiment is generally similar to the lighting apparatus 1000a described with reference to FIG. 10, except that it further includes a light emitting diode 101 that emits blue light and a light emitting diode 103 that emits green light.

White light may be realized by driving a blue light emitting diode 101 and a green light emitting diode 103 together with a light emitting diode 100 that emits yellow light or red light. In addition, a color of light emitted from the light emitting diode 100 may be changed by adjusting a current applied to the light emitting diode 100, and accordingly, a color temperature of light emitted from the lighting apparatus 1000b may be changed.

Although light bulb-shaped lighting apparatuses are illustrated in FIGs. 10 and 11, the lighting apparatuses of the present disclosure are not limited to the light bulb-shaped lighting apparatuses, and may be implemented as lighting apparatuses of various shapes.

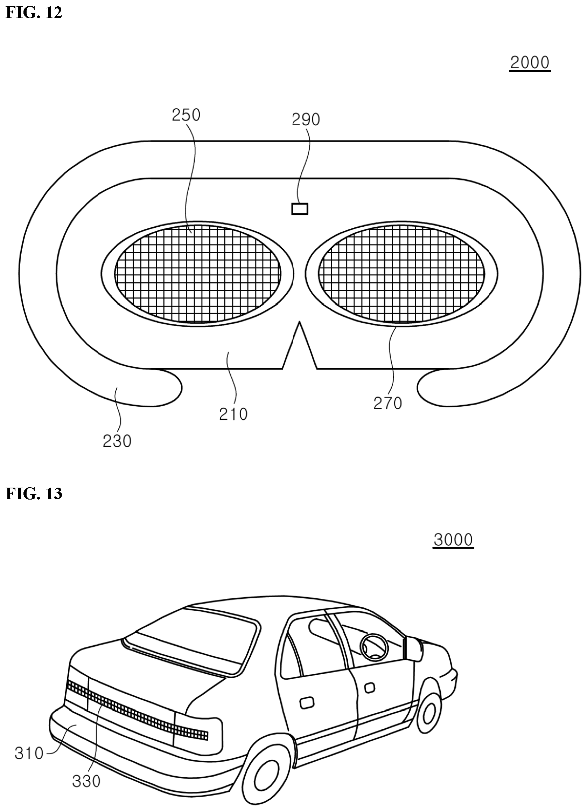

FIG. 12 is a schematic plan view illustrating a head mounted display (HMD) apparatus according to an embodiment of the present disclosure. Augmented reality (AR), virtual reality (VR), and mixed reality (MR) may be experienced through the head-mounted display apparatus.

Referring to FIG. 12, a head mounted display apparatus 2000 may include a main body 210, a protection cushion 230, a display panel 250, an eyepiece 270, and a sensing apparatus 290.

The display panel 250 may include arranged micro LEDs, and blue, green, and red LEDs may be arranged in pixel units to implement colors. Light emitting diodes 100 of the present disclosure may be disposed on the display panel 250 as red LEDs. Since the light emitting diodes 100 are nitride-based light emitting diodes, the red LEDs along with the blue and green LEDs may all be formed of the nitride-based light emitting diodes. Therefore, even when small micro LEDs are arranged, efficiencies of the light emitting diodes may be prevented from decreasing, and light angle distributions of blue, green, and red light emitting diodes may be maintained similarly, thereby reducing color changes depending on an observation angle. Furthermore, a display with low temperature sensitivity may be provided.

Meanwhile, the sensing apparatus 290 includes a light source that irradiates light to a target and a sensor that senses light reflected from the target. The light emitting diode 100 described above may be used as a light source in the sensing apparatus 290 that irradiates light toward the target. In particular, in the head mounted display apparatus 2000, a sensing light source may be used for face recognition and body recognition. For example, the light emitting diode 100 of the present disclosure emits light of a relatively short wavelength at a high intensity under a relatively high current, and emits light of a relatively long wavelength at a low intensity under a relatively low current. Therefore, the light emitting diode 100 may be used as a light source for facial recognition to detect whether the head mounted display apparatus 2000 is worn under the relatively high current, and meanwhile, after the head mounted display apparatus 2000 is worn on the human body, it may be used as a light source for body recognition under the relatively low current.

Accordingly, one type of light emitting diode 100 of the present disclosure may be used as the light source for face recognition and body recognition, thereby simplifying a structure of the sensing apparatus.

FIG. 13 is a schematic perspective view illustrating a vehicle 3000 equipped with a light emitting diode according to an embodiment of the present disclosure.

Referring to FIG. 13, the vehicle 3000 includes a body 310 and a tail light 330 mounted on the body. The tail light 330 may emit red light and yellow light. A light emitting diode 100 according to this embodiment may emit red light or yellow light by changing a current. Therefore, by disposing the light emitting diodes 100 of the present disclosure in the tail light 330, red light or yellow light may be emitted using same light emitting diodes 100. For example, when braking the vehicle, the light emitting diode may be driven under a low current to emit deep red light, while for direction indication, the light emitting diode may be driven under a high current to emit yellow light. In addition, the current applied to the light emitting diode may be changed to emit light of various colors for indicating tail lights or a state of reversing the vehicle.

Although various application examples using the light emitting diode 100 of the present disclosure have been described above, the application examples of the light emitting diode 100 of the present disclosure are not limited to those described above. The light emitting diode 100 may also be used in a large micro LED display, and in addition, may also be used as a light source in a skin treatment apparatus for skin treatment. In particular, since a wavelength of emitted light may be changed by changing the current, the skin may be treated at various depths from the epidermis to the dermis using the same light emitting diode 100. Therefore, the skin treatment apparatus according to the present disclosure may change the depth of the skin to be treated by changing the current. For example, a high current may treat the epidermis, and a low current may treat the dermis.

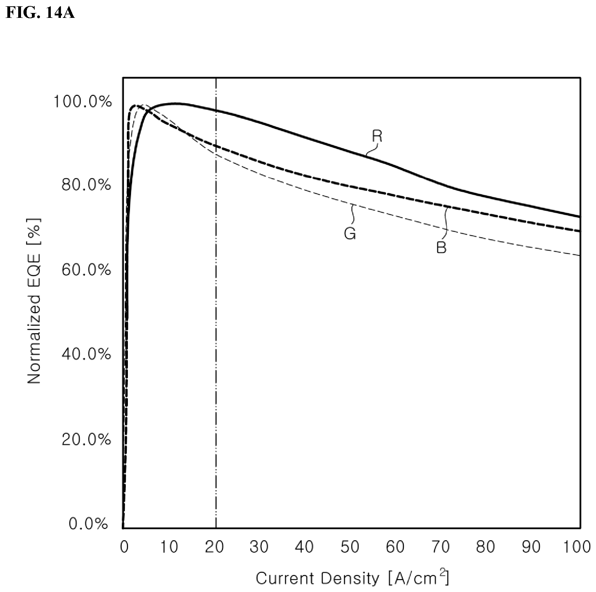

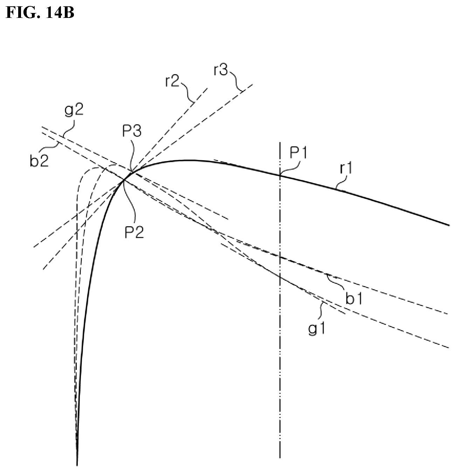

External quantum efficiency characteristics exhibited by the light emitting diode 100 of the present disclosure are described with reference to FIGs. 14A and 14B.

FIG. 14A is a graph illustrating normalized external quantum efficiencies of light emitting diodes according to current density, and FIG. 14B is an enlarged graph of a portion of FIG. 14A.

Referring to FIGs. 14A and 14B, an indication line R indicates an external quantum efficiency graph of a red light emitting diode 100 manufactured according to an embodiment of the present disclosure, an indication line G indicates an external quantum efficiency graph of a green light emitting diode, and an indication line B indicates an external quantum efficiency graph of a blue light emitting diode. The green light emitting diode and the blue light emitting diode may be light emitting diodes used together with the red light emitting diode 100 in a light emitting apparatus, and in addition, may be typical nitride-based green and blue light emitting diodes. For example, the green and blue light emitting diodes may be light emitting diodes used in a micro LED display apparatus together with the red light emitting diode.

The red light emitting diode 100 according to this embodiment has a maximum external quantum efficiency within a current density range of 4A/cm² to 20 A/cm², and exhibits the external quantum efficiency of greater than or equal to 90% of the maximum external quantum efficiency within a current density range of 10 A/cm² to 20 A/cm². As described above, when the maximum quantum efficiency of a light emitting device is positioned in the range of 4A/cm² to 20 A/cm², in a case of using a small light emitting diode such as a micro display or even in a low-current driving apparatus of less than or equal to 1uA to 10mA, high efficiency may be achieved. In addition, when a light emitting apparatus is used in a section where the external quantum efficiency is greater than or equal to 90% of the maximum external quantum efficiency, a thermal efficiency of an electric light emitting apparatus may be improved.

In the graph of FIG. 14A, a vertical dotted line marks a point where the current density is 20 A/cm². The normalized external quantum efficiency of the red light emitting diode 100 has a value higher than that of the normalized external quantum efficiency of blue or green light emitting diodes within the current density range of 10 A/cm² to 20 A/cm². Through this, a light uniformity of the light emitting module may be increased, and a relatively low red luminous efficacy may be compensated to implement the light emitting module with high color purity.

Meanwhile, a normalized external quantum efficiency graph R of the red light emitting diode 100 has a negative slope r1 at a first point P1 where the current density is 20 A/cm². Normalized external quantum efficiency graphs B and G of blue and green light emitting diodes also have negative slopes b1 and g1 at the first point P1. At the first point P1, an absolute value of the slope r1 of the normalized external quantum efficiency graph of the red light emitting diode 100 is smaller than absolute values of the slopes b1 and g1 of the normalized external quantum efficiency graphs B and G of the blue and green light emitting diodes. Though this, it can be seen that the red light emitting diode 100 is more stable to current changes than the green or blue light emitting diode at 20A/cm².

The current density at which the red light emitting diode 100 has the maximum external quantum efficiency is higher than the current densities at which the blue light emitting diode and the green light emitting diode have the maximum external quantum efficiency. In addition, the current density at which the green light emitting diode has the maximum external quantum efficiency has a value higher than the current density at which the blue light emitting diode has the maximum external quantum efficiency. When the light emitting diodes are driven at the current density at which the red light emitting diode 100 has the maximum external quantum efficiency, a reliability of the red light emitting diode may be improved.

The normalized external quantum efficiency graph R of the red light emitting diode 100 intersects with the normalized external quantum efficiency graphs B and G of the blue light emitting diode and the green light emitting diode at a second point P2 and a third point P3, respectively. The second point P2 may be positioned at a lower current density than that of the third point P3. More preferably, an intersection point of the green light emitting diode and the red light emitting diode, which have relatively low luminous intensity, intersects at a higher current density than that of an intersection point of the blue light emitting diode and the red light emitting diode, so that the green light emitting diode and the red light emitting diode may be driven in a relatively high external quantum efficiency region, thereby improving the reliability of the green and red light emitting diodes and increasing the light uniformity of the light emitting module.

The second point P2 and the third point P3 are current densities smaller than 10A/cm². In an embodiment, driving current densities of the light emitting diodes may be greater than the current density at the third point P3 and smaller than 20 A/cm². In this case, under the driving current densities, the normalized external quantum efficiency of the red light emitting diode 100 is higher than those of the blue and green light emitting diodes. Since a rate of change near the maximum quantum efficiency is small, it may be driven between 10 A/cm² and 20 A/cm², its stability according to current change or size may be improved.

Meanwhile, the normalized external quantum efficiency graph R of the red light emitting diode 100 has a positive slope r2 at the second point P2. On the contrary, the normalized external quantum efficiency graph B of the blue light emitting diode has a negative slope b2 at the second point P2. The slope r2 may be greater than an absolute value of the slope b2. In addition, the normalized external quantum efficiency graph of the red light emitting diode 100 has a positive slope r3 at the third point P3. On the contrary, the normalized external quantum efficiency graph G of the green light emitting diode has a negative slope g2 at the third point P3. The slope r3 may be greater than the slope g2.

As shown in FIG. 14A, the graphs R, G, and B show a trend of rapidly increasing as the current density increases and gradually decreasing after passing the maximum quantum efficiency. The graphs R, G, and B have a section where they increase rapidly and then decrease gradually, have a minimum radius of curvature in this section, and this section is smaller than 20 A/cm². The minimum radii of curvature of the graphs R, G, and B are different from one another. In an embodiment, as illustrated in FIG. 14A, the minimum radius of curvature of the graph R is larger than the minimum radii of curvature of the graph B and the graph G, and the larger the radius of curvature, the smaller the rate of change in current density, and thus, the light emitting diode may be stably driven in a small size or at a low current.

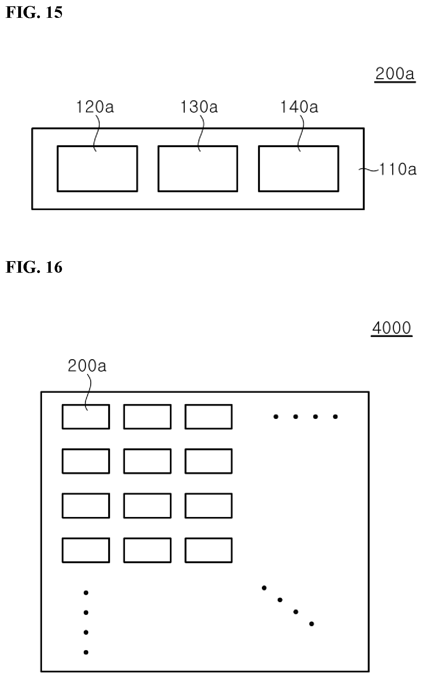

FIG. 15 is a schematic plan view illustrating a light emitting module 200a according to an embodiment of the present disclosure.

Referring to FIG. 15, the light emitting module 200a includes a substrate 110a, a first light emitting diode 120a disposed on one surface of the substrate 110a and emitting light having a first peak wavelength, a second light emitting diode 130a disposed on one surface of the substrate 110a and emitting light having a second peak wavelength, and a third light emitting diode 140a disposed on one surface of the substrate 110a and emitting light having a third peak wavelength.

The substrate 110a is a substrate on which a plurality of light emitting diodes 120a, 130a, and 140a is mounted on an upper surface thereof, and is not limited to a specific type as long as it can support light emitting diodes, such as a circuit board, a lead frame, a flexible substrate, a transparent substrate, and the like.

The first to third light emitting diodes 120a, 130a, and 140a may emit light of different peak wavelengths from one another, or may be the plurality of light emitting diodes 120a, 130a, and 140a of which the difference between their peak wavelengths is within a range of 5 nm. At least one of the first to third light emitting diodes 120a, 130a, and 140a may be a nitride-based light emitting diode that emits red light. In an embodiment, all of the first to third light emitting diodes 120a, 130a, and 140a may be the nitride-based light emitting diodes that emit red light, and the difference in peak wavelengths of light emitted from these light emitting diodes may be within 5 nm, enabling uniform color implementation. In another embodiment, the first to third light emitting diodes 120a, 130a, and 140a may include nitride-based light emitting diodes that emit red light, green light, and blue light, and the difference in peak wavelengths of light emitted from the diodes may be greater than or equal to 10 nm, and when the difference in peak wavelengths is greater than or equal to 10 nm, a wide color gamut may be achieved. In the drawing, they are illustrated as being the first to third, but a number thereof is not limited thereto.

The substrate 110a has an insulation layer and an interconnection for electrical connection with the first to third light emitting diodes 120a, 130a, and 140a, and may include circuits for supplying an electrical source such as current or voltage to the first to third light emitting diodes 120a, 130a, and 140a and driving them.

On the upper surface of the substrate 110a, pads for mounting first to third light emitting diodes 120a, 130a, and 140a may be formed, and on a lower surface of the substrate 110a, pads for mounting on another substrate (for example, a display substrate or a circuit board) may also be formed. The substrate 110a may be formed in a single-layer or multi-layer structure, and may be formed in various thicknesses as needed. It may have a thickness larger than those of the first to third light emitting diodes 120a, 130a, and 140a, and may protect the light emitting diodes from external impact.

The plurality of light emitting diodes 120a, 130a, and 140a may be laterally spaced apart from one another on the substrate 110a. However, the inventive concepts are not limited thereto, and the first to third light emitting diodes 120a, 130a, and 140a may be arranged in a vertical stack to dispose multiple light emitting diodes in a narrow space.

A cover layer may be formed on the plurality of light emitting diodes 120a, 130a, and 140a. The cover layer may cover the plurality of light emitting diodes 120a, 130a, and 140a, and may further include various fillers, light-absorbing materials such as carbon black, light-reflection materials, and others to increase light extraction efficiency. The cover layer may function as a kind of buffer layer and may cover not only the light emitting diodes but also the upper surface of the substrate 110a.

The cover layer may encapsulate the plurality of light emitting diodes 120a, 130a, and 140a, may also function as a refraction layer that refracts light emitted therefrom, and may adjust a projection angle.

The cover layer may be formed of a single layer or a plurality of layers, and may be a light-transmitting transparent molding for transmitting light emitted from the light emitting diodes 120a, 130a, and 140a.

The cover layer may be formed of a resin including one or more of silicone, epoxy, PMMA (Polymethyl methacrylate), and PS (Polystyrene) series. In addition, the cover layer may be formed of a fluorine resin to improve the extraction efficiency of light emitted from the plurality of light emitting diodes 120a, 130a, and 140a.

Meanwhile, the cover layer may further include a light diffuser capable of diffusing light emitted from the plurality of light emitting diodes 120a, 130a, and 140a, and for example, the light diffuser may include one or more of TiO₂, BaO, SiO₂, and MgO, Y₂O₃ capable of scattering light, and they may be distributed inside the cover layer.

In addition, the cover layer may further include a wavelength conversion material capable of converting a wavelength of light emitted from the plurality of light emitting diodes 120a, 130a, and 140a. For example, the wavelength conversion material may include a phosphor emitting one or more of red light, blue light, and green light, and may be distributed inside the cover layer.

The light emitting module 200a according to this embodiment may be a light emitting apparatus itself, or may be used in various light emitting apparatuses such as other lighting apparatuses or display apparatuses. Hereinafter, a display apparatus 4000 including the light emitting module 200a is described.

FIG. 16 is a schematic plan view illustrating the display apparatus 4000 according to an embodiment of the present disclosure.

Referring to FIG. 16, the display apparatus 4000 may include a plurality of light emitting modules 200a. Each of the light emitting modules 200a may include nitride-based blue, green, and red light emitting diodes. The light emitting module 200a may form at least one pixel. The light emitting module 200a may be arranged on a circuit board, and may be operated to implement an image by receiving power through an interconnection on the circuit board.

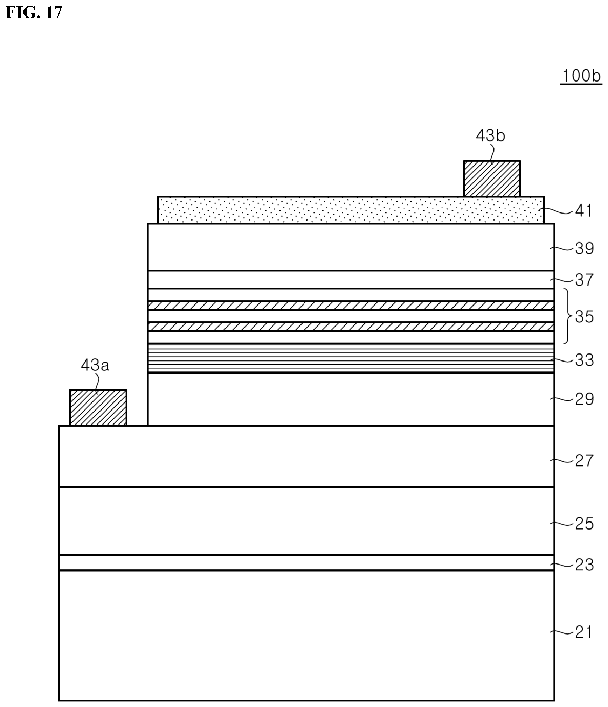

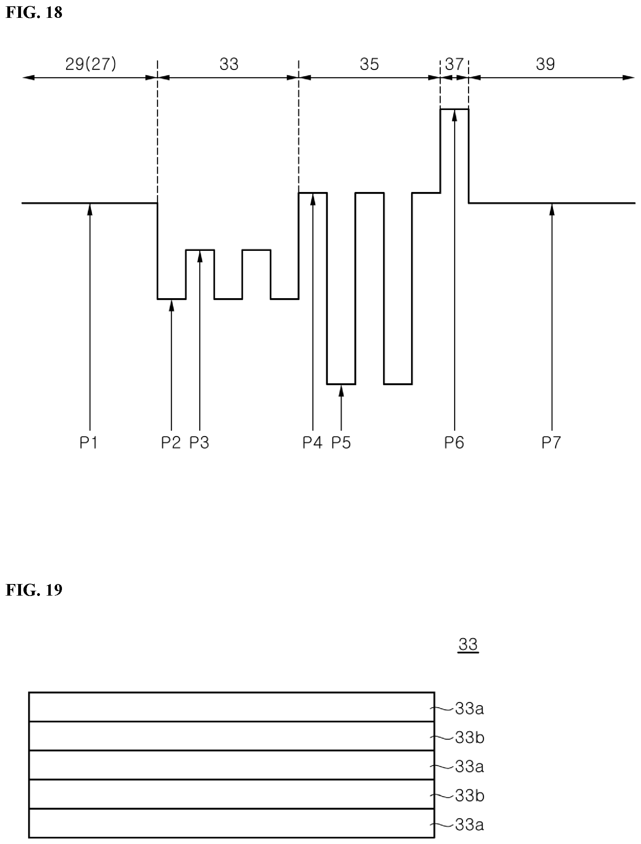

FIG. 17 is a schematic cross-sectional view illustrating a light emitting diode 100b according to an embodiment of the present disclosure, and FIG. 18 is a schematic drawing illustrating a band gap of each layer of the light emitting diode according to an embodiment of the present disclosure.

Referring to FIG. 17, the light emitting diode 100b may include a substrate 21, a buffer layer 23, an undoped layer 25, a first conductivity type semiconductor layer 27, a strain control layer 29, a superlattice layer 33, an active region 35, an electron blocking layer 37, a second conductivity type semiconductor layer 39, a transparent electrode layer 41, a first electrode 43a, and a second electrode 43b. The substrate 21, the buffer layer 23, the first conductivity type semiconductor layer 27, the strain control layer 29, the superlattice layer 33, the active region 35, the electron blocking layer 37, the second conductivity type semiconductor layer 39, the transparent electrode layer 41, the first electrode 43a, and the second electrode 43b are similar to those described in the previous embodiment, and thus, detailed descriptions thereof are omitted herein to avoid redundancy.

In this embodiment, the first conductivity type semiconductor layer 27 may be expressed by the following formula 1:
(Formula 1) AₓB_{y}C_{z}D_{(1-x-y-z)}, where A may be an element selected from Al, In, and Ga, B may be an element selected from Al, In, and Ga, C may be an element selected from Al, In, and Ga, D may be nitrogen, A, B, and C may be different elements, it may be x+y+z=0.5, and 0≤x, y, z≤0.5.

However, the first conductivity type semiconductor layer 27 may include Ga and N.

Meanwhile, an index P representing a band gap of a nitride semiconductor layer expressed by the Formula 1 in this specification may be expressed as (αx+βy+γz), where α, β, and γ represent band gaps of AD, BD, and CD, respectively. For example, when AD, BD, and CD are AlN, GaN, and InN, respectively, α, β, and γ may be 0.62, 3.4, and 6.2, respectively.

The superlattice layer 33 may be formed of InGaN/GaN or InGaN/InGaN, and may be formed by stacking in 2 to 6 cycles, for example. As illustrated in FIG. 19, a thickness of the first layer 33a having a high In content within the superlattice layer 33 may be smaller than that of the second layer 33b having a relatively low In content. For example, the thickness of the first layer 33a within the superlattice layer 33 may be about 2.0 nm, and the thickness of the second layer 33b may be about 8.0 nm. A total thickness of the superlattice layer 33 may be, for example, in a range of about 50 nm to about 60 nm, without being limited thereto.

An In composition ratio of the first layer 33a of the superlattice layer 33 with respect to an overall composition of In, Ga, and N may be within a range of 0.025 to 0.05. Meanwhile, a Ga composition ratio of the first layer 33a with respect to the overall composition of In, Ga, and N may be within a range of 0.45 to 0.475.

The superlattice layer 33 may be grown at a relatively slow rate using triethylgallium (TEGa) as a Ga source. V-pits are generated by the strain control layer 29 that grows relatively fast at a low temperature, and sizes of the V-pits increase by the superlattice layer 33. In particular, by growing the superlattice layer 33 using the TEGa source, V-pits with relatively uniform densities and sizes may be formed over an entire wafer area.

By forming the superlattice layer 33 as an InGaN/GaN or InGaN/InGaN superlattice layer, a lattice change may be reduced, thereby reducing defects in the active region 35.

The active region 35 is disposed on the second superlattice layer 33. The active region 35 may include a barrier layer 35a and a well layer 35b as shown in FIG. 4. The active region 35 may have a single quantum well structure including a single well layer 35b or a multiple quantum well structure including a plurality of well layers 35b. For example, a number of well layers 35b may range from 1 to 10.

Each of a composition of the barrier layer 35a and the well layer 35b may be expressed by the Formula 1 described above, that is, AₓB_{y}C_{z}D_{(1-x-y-z)}. However, the well layer 35b includes an In content higher than that of the barrier layer 35a to emit red light. An In composition ratio in the well layer 35b may be greater than or equal to 0.15 and less than or equal to 0.2 with respect to an overall composition in the well layer 35b.

The electron blocking layer 37 is disposed on the active region 35. The electron blocking layer 37 is formed along a surface of the active region 35. The electron blocking layer 37 may include a plurality of layers 37a, 37b, and 37c, as shown in FIG. 5. A lowermost layer 37a may be in contact with a last barrier layer 35a of the active region 35, an uppermost layer 37c may be in contact with the second conductivity type semiconductor layer 39, and an intermediate layer 37b may be disposed between the lowermost layer 37a and the uppermost layer 37c. For example, the lowermost layer 37a may be formed with a thickness of about 2 nm to 3 nm, the intermediate layer 37b may be formed with a thickness of about 10 nm to 15 nm, and the uppermost layer 37c may be formed with a thickness of about 12 nm to 20 nm.

The intermediate layer 37b may include a higher concentration of a p-type impurity than those of the lowermost layer 37a and the uppermost layer 37c. For example, the intermediate layer 37b may include Mg doped at a high concentration of about 1×10²⁰/cm³ to about 3×10²⁰/cm³.

A composition formula of each layer in the electron blocking layer 37 may be expressed by the Formula 1 described above. However, each layer within the electron blocking layer 37 may include Al. The lowermost layer 37a may be, for example, an AlN layer. In addition, the uppermost layer 37c may be a grading layer in which a composition ratio of Al decreases as it gets farther from the active region 35. For example, the uppermost layer 37c may be an AlGaN grading layer. In addition, an Al composition ratio of the intermediate layer 37b may be smaller than that of the lowermost layer 37a, may be smaller than a maximum Al composition ratio and larger than a minimum Al composition ratio in the uppermost layer 37c, which is the grading layer. For example, the intermediate layer 37b may be an InAlGaN layer.

The second conductivity type semiconductor layer 39 may be disposed on the electron blocking layer 37.

Each of layers 39a, 39b, and 39c of the second conductivity type semiconductor layer 39 may be represented as a formula 1 similarly to the first conductivity type semiconductor layer 27.

(Formula 1) AₓB_{y}C_{z}D_{(1-x-y-z)}, where A may be an element selected from Al, In, and Ga, B may be an element selected from Al, In, and Ga, C may be an element selected from Al, In, and Ga, D may be nitrogen, A, B, and C may be different elements, it may be x+y+z=0.5, and 0≤x, y, z≤0.5.

However, at least one of the first to third layers 39a to 39c necessarily includes Ga. The first to third layers 39a to 39c may be formed with a same composition.

Referring to FIG. 18, the index P representing the band gap of each layer may be calculated as (αx+βy+γz). An index representing a band gap of the first conductivity type semiconductor layer 27 or the strain control layer 29 may be represented as a P1, indices of band gaps of the first and second layers in the superlattice layer 33 may be represented as a P2 and a P3, respectively, an index of that of the barrier layer 35a may be represented as a P4, an index of that of the well layer 35b may be represented as a P5, an index of that of the electron locking layer 37 may be represented as a P6, and an index of that of the second conductivity type semiconductor layer 39 may be represented as a P7. To distinguish a calculation formula for calculating each index value, each formula can be written as (αx+βy+γz)_{P}. For example, a calculation formula for the P1 can be written as (αx+βy+γz)_{P1}, and a calculation formula for the P2 can be expressed as (αx+βy+γz)_{P2.}

In the embodiments of the present disclosure, the index value P5 of at least one well layer 35b is smaller than the index value P1 of the first conductivity type semiconductor layer 27 or the strain control layer 39, and satisfies the following equation 1.${\left(αx+βy+γz\right)}_{P 5} - {\left(αx+βy+γz\right)}_{P 1} < 0 .$

A value of the index value P5 minus the index value P1 may be negative. Alternatively, an absolute value of the index value P5 minus the index value P1 may be greater than or equal to 0.6.

In addition, in the embodiments of the present disclosure, the index value P5 of the well layer 35b is smaller than the index value P2 of at least one first layer 33a in the superlattice layer 33, and satisfies the following equation 2.${\left(αx+βy+γz\right)}_{P 5} - {\left(αx+βy+γz\right)}_{P 2} < 0 .$

A value of the index value P5 minus the index value P2 may be negative. Alternatively, an absolute value of the index value P5 minus the index value P2 may be greater than or equal to 0.5. Therefore, it is possible to prevent light generated in the well layer 35b from being absorbed in the first layer 33a.

In addition, in the embodiments of the present disclosure, the index value P5 of the well layer 35b is smaller than the index value P3 of at least one second layer 33b in the superlattice layer 33, and satisfies the following equation 3.${\left(αx+βy+γz\right)}_{P 5} - {\left(αx+βy+γz\right)}_{P 3} < 0 .$

A value of the index value P5 minus the index value P3 may be negative. Alternatively, an absolute value of the index value P5 minus the index value P3 may be greater than or equal to 0.6. The absolute value of the index value P5 minus the index value P2 may be smaller than the absolute value of the index value P5 minus the index value P3. Therefore, electrons supplied to a light emitting device may move smoothly to the well layer 35b.

In addition, in the embodiments of the present disclosure, the index value P5 of the well layer 35b is smaller than the index value P4 of the barrier layer 35a in contact with the well layer 35b, and satisfies the following equation 4.${\left(αx+βy+γz\right)}_{P 5} - {\left(αx+βy+γz\right)}_{P 4} < 0 .$

A value of the index value P5 minus the index value P4 may be negative. Alternatively, an absolute value of the index value P5 minus the index value P4 may be greater than or equal to 0.9. A value of the index value P4 minus the index value P5 may be smaller than a value of the index value P3 minus the index value P2. Therefore, a probability that electrons supplied to the light emitting device are trapped in the well layer 35b may be increased.

Two barrier layers 35a may be in contact with each well layer 35b, and in this case, the well layer 35b and the two barrier layers 35a may satisfy the Equation 4, respectively. Accordingly, the active region 35 may emit red light.

In the embodiments of the present disclosure, the index value P5 of the well layer 35b is smaller than the index value P6 of the electron blocking layer 37 and satisfies the following equation 5.${\left(αx+βy+γz\right)}_{P 5} - {\left(αx+βy+γz\right)}_{P 6} < 0 .$

A value of the index value P5 minus the index value P6 may be negative. Alternatively, an absolute value of the index value P5 minus the index value P6 may be greater than or equal to 1.4. A value of the index value P6 minus the index value P5 may be greater than the value of the index value P4 minus the index value P5. Therefore, electrons may be prevented from moving to the second conductivity type semiconductor layer 39.

When the electron blocking layer 37 includes an inclination composition layer, the P6 may be calculated as a layer having a maximum band gap of the inclination composition layer.

In the embodiments of the present disclosure, the index value P5 of the well layer 35b is smaller than the index value P7 of the second conductivity type semiconductor layer 39 and satisfies the following equation 6. ${\left(αx+βy+γz\right)}_{P 5} - {\left(αx+βy+γz\right)}_{P 7} < 0 .$

A value of the index value P5 minus the index value P7 may be negative. Alternatively, an absolute value of the index value P5 minus the index value P7 may be greater than or equal to 0.6. A value of the index value P6 minus the index value P7 may be greater than a value of the index value P6 minus the index value P4. Therefore, light generated in the well layer 35b may be prevented from being absorbed in the second conductivity type semiconductor layer 39.

Meanwhile, in the embodiments of the present disclosure, the index value P4 of the barrier layer 35a is greater than or equal to the index value P1 of the first conductivity type semiconductor layer 27 or the strain control layer 29, and satisfies the following equation 7.${\left(αx+βy+γz\right)}_{P 4} - {\left(αx+βy+γz\right)}_{P 1} \geq 0 .$

A value of the index value P4 minus the index value P1 may be positive. Alternatively, the value of the index value P4 minus the index value P1 may be greater than 0.15.

The index value P4 of the barrier layer 35a may be greater than the index value P1 of the first conductivity type semiconductor layer 27 or the strain control layer 29.

In addition, in the embodiments of the present disclosure, the index value P4 of the barrier layer 35a is not smaller than the index value P3 of the second layer 33b in the superlattice layer 33, and satisfies the following equation 8.${\left(αx+βy+γz\right)}_{P 4} - {\left(αx+βy+γz\right)}_{P 3} \geq 0 .$

The index value P4 of the barrier layer 35a may be greater than the index value P3 of the second layer 33b. A value of the index value P4 minus the index value P3 may be positive. The value of the index value P4 minus the index value P3 may be greater than 0.2. Therefore, an index value of a layer playing a role as a barrier may be increased as it gets closer to the second conductivity type semiconductor layer 39, thereby improving a flow of electrons and holes.

In the embodiments of the present disclosure, the index value P4 of the barrier layer 35a is smaller than the index value P6 of the electron blocking layer 37, and satisfies the following equation 9. ${\left(αx+βy+γz\right)}_{P 4} - {\left(αx+βy+γz\right)}_{P 6} < 0 .$

A value of the index value P4 minus the index value P6 may be negative. Alternatively, an absolute value of the index value P4 minus the index value P6 may be greater than or equal to 0.4.

In the embodiments of the present disclosure, the index value P4 of the barrier layer 35a is greater than or equal to the index value P7 of the second conductivity type semiconductor layer 39, and satisfies the following equation 10.${\left(αx+βy+γz\right)}_{P 4} - {\left(αx+βy+γz\right)}_{P 7} \geq 0 .$

A value of the index value P4 minus the index value P7 may be positive. Alternatively, the value of the index value P4 minus the index value P7 may be greater than or equal to 0.1.

The index value P4 of the barrier layer 35a may be greater than the index value P7 of the second conductivity type semiconductor layer 39.

The index value P3 of at least one second layer 33b of the superlattice layer 33 is smaller than or equal to the index value P1 of the first conductivity type semiconductor layer 27 or the strain control layer 29, and satisfies the following equation 11.${\left(αx+βy+γz\right)}_{P 3} - {\left(αx+βy+γz\right)}_{P 1} \leq 0 .$

A value of the index value P3 minus the index value P1 may be negative. Alternatively, an absolute value of the index value P3 minus the index value P1 may be greater than or equal to 0.01.

The index value P3 of at least one second layer 33b of the superlattice layer 33 may be smaller than the index value P1 of the first conductivity type semiconductor layer 27 or the strain control layer 29.

The index value P3 of at least one second layer 33b of the superlattice layer 33 is smaller than or equal to the index value P7 of the second conductivity type semiconductor layer 39, and satisfies the following equation 12.${\left(αx+βy+γz\right)}_{P 3} - {\left(αx+βy+γz\right)}_{P 7} \leq 0 .$

A value of the index value P3 minus the index value P7 may be negative. Alternatively, an absolute value of the index value P3 minus the index value P7 may be greater than or equal to 0.01.

The index value P3 of at least one second layer 33b of the superlattice layer 33 may be smaller than the index value P7 of the second conductivity type semiconductor layer 39.

The light emitting diode 100b of the present disclosure may further include a lower superlattice layer 31 as described with reference to FIGs. 1 and 2, and a detailed description thereof is omitted.

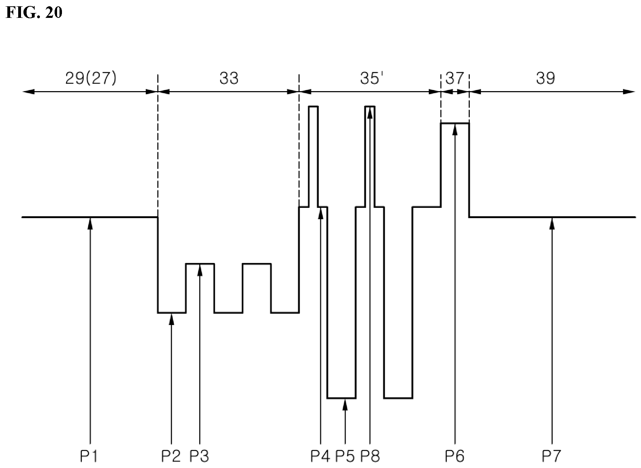

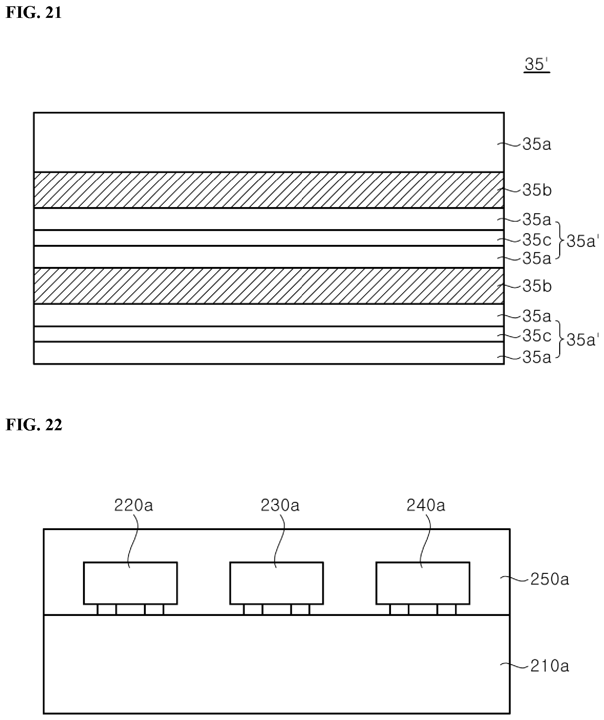

FIG. 20 is a band diagram illustrating a light emitting diode according to another embodiment of the present disclosure, and FIG. 21 is an enlarged cross-sectional view of an active region 35' of the light emitting diode according to another embodiment of the present disclosure.

Referring to FIGs. 20 and 21, the light emitting diode according to this embodiment is similar to the light emitting diode described with reference to FIG. 17, except that a barrier layer 35a' of the active region 35' includes a protruding band gap layer 35c together with a reference band gap layer 35a. The reference band gap layer 35a has an index value P4 representing a band gap of the barrier layer 35a described in the above embodiments, and the protruding band gap layer 35c has a band gap wider than that of the reference band gap. The band gap of the protruding band gap layer 35c is wider than that of an electron blocking layer 37.

The protruding band gap layer 35c may be disposed as an intermediate layer between the reference band gap layers 35a within the barrier layer 35a' as shown in FIGs. 20 and 21, but the inventive concepts are not limited thereto. The protruding band gap layer 35c may be formed as an initiation layer of the barrier layer 35a' or a termination layer of the barrier layer 35a' to be in contact with a well layer 35b. The protruding band gap layer 35c may be formed within all barrier layers within the active region 35'. In an embodiment, a last barrier layer 35a in contact with the electron blocking layer 37 may not include the protruding band gap layer 35c.

An index value P8 representing the band gap of the protruding band gap layer 35c is greater than the index value P4 of the reference barrier layer 35a, and satisfies the following equation 13.${\left(αx+βy+γz\right)}_{P 8} - {\left(αx+βy+γz\right)}_{P 4} > 0 .$

The index value P8 representing the band gap of the protruding band gap layer 35c is greater than an index value P6 representing the band gap of the electron blocking layer 37, and satisfies the following equation 14.${\left(αx+βy+γz\right)}_{P 8} - {\left(αx+βy+γz\right)}_{P 6} > 0 .$

In an embodiment, the protruding band gap layer 35c may be an AlN layer.

FIG. 22 is a schematic cross-sectional view illustrating a light emitting apparatus according to an embodiment of the present disclosure.

Referring to FIG. 22, the light emitting apparatus includes a substrate 210a, a first light emitting diode 220a disposed on one surface of the substrate 210a and emitting light having a first peak wavelength, a second light emitting diode 230a disposed on one surface of the substrate 210a and emitting light having a second peak wavelength, and a third light emitting diode 240a disposed on one surface of the substrate 210a and emitting light having a third peak wavelength.

The substrate 210a is a substrate on which a plurality of light emitting diodes 220a, 230a, and 240a is mounted on an upper surface thereof, and is not limited to a specific type as long as it can support light emitting diodes, such as a circuit board, a lead frame, a flexible substrate, a transparent substrate, and the like.

The first to third light emitting diodes 220a, 230a, and 240a may emit light of different peak wavelengths from one another, or may be the plurality of light emitting diodes 220a, 230a, and 240a of which the peak wavelengths have a difference within a range of 5 nm. At least one of the first to third light emitting diodes 220a, 230a, and 240a may be a nitride-based light emitting diode that emits red light. In an embodiment, all of the first to third light emitting diodes 220a, 230a, and 240a may be nitride-based light emitting diodes that emit red light, and the difference in peak wavelengths of light emitted from these light emitting diodes may be within 5 nm. In another embodiment, the first to third light emitting diodes 220a, 230a, and 240a may include nitride-based light emitting diodes that emit red light, green light, and blue light. In the drawing, they are illustrated as being the first to third, but a number thereof is not limited thereto.

The substrate 210a has an insulation layer and an interconnection for electrical connection with the first to third light emitting diodes 220a, 230a, and 240a, and may include circuits for supplying an electrical source such as current or voltage to the first to third light emitting diodes 220a, 230a, and 240a and driving them.

On the upper surface of the substrate 210a, pads for mounting first to third light emitting diodes 220a, 230a, and 240a may be formed, and on a lower surface of the substrate 210a, pads for mounting on another substrate (not shown in the drawings, for example, a display substrate or a circuit board) may be formed. The substrate 210a may be formed in a single-layer or multi-layer structure, and may be formed in various thicknesses as needed.

The plurality of light emitting diodes 220a, 230a, and 240a may be laterally spaced apart from one another on the substrate 210a. However, the inventive concepts are not limited thereto, and the first to third light emitting diodes 220a, 230a, and 240a may be arranged in a vertical stack.

A cover layer 250a may be formed on the plurality of light emitting diodes 220a, 230a, and 240a. The cover layer 250a may cover the plurality of light emitting diodes 220a, 230a, and 240a, and may further include various fillers, light-absorbing materials such as carbon black, light-reflection materials, or others to increase light extraction efficiency. The cover layer 250a may function as a kind of buffer layer and may cover not only the light emitting diodes but also the upper surface of the substrate 210a.

The cover layer 250a may encapsulate the plurality of light emitting diodes 220a, 230a, and 240a, and may also function as a refraction layer that refracts light emitted therefrom.

The cover layer 250a may be formed of a single layer or a plurality of layers, and may be a light-transmitting transparent molding for transmitting light emitted from the light emitting diodes 220a, 230a, and 240a.

For example, the cover layer 250a may be formed of a resin including one or more of silicone, epoxy, PMMA (Polymethyl methacrylate), and PS (Polystyrene) series. In addition, the cover layer 250a may be formed of a fluorine resin to improve the light extraction efficiency emitted from the plurality of light emitting diodes 220a, 230a, and 240a.

Meanwhile, the cover layer 250a may further include a light diffuser capable of diffusing light emitted from the plurality of light emitting diodes 220a, 230a, and 240a, and for example, the light diffuser may include one or more of TiO₂, BaO, SiO₂, and MgO, Y₂O₃ capable of scattering light, and they may be distributed within the cover layer 250a.

In addition, the cover layer 250a may further include a wavelength conversion material capable of converting a wavelength of light emitted from the plurality of light emitting diodes 220a, 230a, and 240a. For example, the wavelength conversion material may include a phosphor emitting one or more of red light, blue light, and green light, and may be distributed inside the cover layer.

While specific embodiments and aspects of the present disclosure have been illustrated and described, various changes and modifications may be made without departing from the spirit and scope of the present disclosure. Moreover, although various aspects are described herein, these aspects need not be used in combination. Accordingly, the following claims are intended to cover all changes and modifications within the scope shown and described herein.

## Claims

1. A light emitting diode emitting red light, comprising:
a first conductivity type semiconductor layer;
an active region including a barrier layer and a well layer;
a strain control layer disposed between the first conductivity type semiconductor layer and the active region;
a superlattice layer disposed between the strain control layer and the active region;
a second conductivity type semiconductor layer disposed on the active region; and
an electron blocking layer disposed between the active region and the second conductivity type semiconductor layer,
wherein a composition of each layer is expressed by the following formula 1, and an index value P5 representing a band gap of the well layer and an index value P1 representing a band gap of the first conductivity type semiconductor layer satisfy the following equation 1:
(Formula 1) AₓB_{y}C_{z}D_{(1-x-y-z)} (where A is an element selected from Al, In, and Ga, B is an element selected from Al, In, and Ga, C is an element selected from Al, In, and Ga, D is nitrogen, A, B, and C are different elements from one another, x+y+z=0.5, and 0≤x, y, z≤0.5); and ${\left(αx+βy+γz\right)}_{P 5} - {\left(αx+βy+γz\right)}_{P 1} < 0$ (where α, β, and γ represent band gaps of AD, BD, and CD, respectively).

2. The light emitting diode of claim 1, wherein the superlattice layer has a structure in which a first layer and a second layer are alternately stacked, and the first layer contains more In than the second layer, and the index value P5 representing the band gap of the well layer and an index value P2 representing a band gap of the first layer of the superlattice layer satisfy the following equation 2: ${\left(αx+βy+γz\right)}_{P 5} - {\left(αx+βy+γz\right)}_{P 2} < 0 .$

3. The light emitting diode of claim 2, wherein the index value P5 representing the band gap of the well layer and an index value P3 representing a band gap of the second layer of the superlattice layer satisfy the following equation 3: ${\left(αx+βy+γz\right)}_{P 5} - {\left(αx+βy+γz\right)}_{P 3} < 0 .$

4. The light emitting diode of claim 1, wherein the index value P5 representing the band gap of the well layer and an index value P4 representing a band gap of the barrier layer satisfy the following equation 4: ${\left(αx+βy+γz\right)}_{P 5} - {\left(αx+βy+γz\right)}_{P 4} < 0 .$

5. The light emitting diode of claim 4, wherein the well layer is in contact with two barrier layers, and the well layer and the two barrier layers satisfy the Equation 4, respectively.

6. The light emitting diode of claim 1, wherein the index value P5 representing the band gap of the well layer and an index value P6 representing a band gap of the electron blocking layer satisfy the following equation 5: ${\left(αx+βy+γz\right)}_{P 5} - {\left(αx+βy+γz\right)}_{P 6} < 0 .$

7. The light emitting diode of claim 1, wherein the index value P5 representing the band gap of the well layer and an index value P7 representing a band gap of the second conductivity type semiconductor layer satisfy the following equation 6: ${\left(αx+βy+γz\right)}_{P 5} - {\left(αx+βy+γz\right)}_{P 7} < 0 .$

8. The light emitting diode of claim 1, wherein the index value P4 representing the band gap of the barrier layer and the index value P1 representing the band gap of the first conductivity type semiconductor layer satisfy the following equation 7: ${\left(αx+βy+γz\right)}_{P 4} - {\left(αx+βy+γz\right)}_{P 1} \geq 0 .$

9. The light emitting diode of claim 8, wherein the index value P4 representing the band gap of the barrier layer is greater than the index value P1 representing the band gap of the first conductivity type semiconductor layer.

10. The light emitting diode of claim 1, wherein the index value P4 representing the band gap of the barrier layer and the index value P3 representing the band gap of the first layer of the superlattice layer satisfy the following equation 8: ${\left(αx+βy+γz\right)}_{P 4} - {\left(αx+βy+γz\right)}_{P 3} \geq 0 .$

11. The light emitting diode of claim 1, wherein the index value P4 representing the band gap of the barrier layer and the index value P6 representing the band gap of the electron blocking layer satisfy the following equation 9: ${\left(αx+βy+γz\right)}_{P 4} - {\left(αx+βy+γz\right)}_{P 6} < 0 .$

12. The light emitting diode of claim 1, wherein the index value P4 representing the band gap of the barrier layer and the index value P7 representing the band gap of the second conductivity type semiconductor layer satisfy the following equation 10: ${\left(αx+βy+γz\right)}_{P 4} - {\left(αx+βy+γz\right)}_{P 7} \geq 0 .$

13. The light emitting diode of claim 12, wherein the index value P4 representing the band gap of the barrier layer is greater than the index value P7 representing the band gap of the second conductivity type semiconductor layer.

14. The light emitting diode of claim 1, wherein the superlattice layer has a structure in which the first layer and the second layer are alternately stacked, the first layer contains more In than the second layer, and the index value P3 representing the band gap of the second layer of the superlattice layer and the index value P1 representing the band gap of the first conductivity type semiconductor layer satisfy the following equation 11: ${\left(αx+βy+γz\right)}_{P 3} - {\left(αx+βy+γz\right)}_{P 1} \leq 0 .$

15. The light emitting diode of claim 14, wherein the index value P3 representing the band gap of the second layer of the superlattice layer and the index value P7 representing the band gap of the second conductivity type semiconductor layer satisfy the following equation 12: ${\left(αx+βy+γz\right)}_{P 3} - {\left(αx+βy+γz\right)}_{P 7} \leq 0 .$
